(19) **Europäisches Patentamt**
**European Patent Office**
**Office européen des brevets**

(11) **EP 4 756 444 A1**

(12) **EUROPEAN PATENT APPLICATION**

(43) Date of publication:
**10.06.2026 Bulletin 2026/24**

(51) International Patent Classification (IPC):
*G01R 31/34* ^(2020.01)

(21) Application number: **24307051.3**

(22) Date of filing: **06.12.2024**

(52) Cooperative Patent Classification (CPC):
**G01R 31/343**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Schneider Toshiba Inverter Europe SAS**
**27120 Pacy-sur-Eure (FR)**

(72) Inventors:
• **SURROOP, Dilshad**
**93200 Saint Denis (FR)**

• **BENBERKANE, Sofiane**
**78300 Poissy (FR)**
• **TFAILY, Ali**
**92500 Rueil Malmaison (FR)**
• **AWDE, Ahmad**
**27200 Vernon (FR)**
• **JEBAI, Al Kassem**
**27200 Vernon (FR)**

(74) Representative: **Plasseraud IP**
**104 Rue de Richelieu**
**CS92104**
**75080 Paris Cedex 02 (FR)**

(54) **METHOD FOR DETECTING A BROKEN BAR OF AN INDUCTION MOTOR AND APPARATUS FOR IMPLEMENTING THE SAME**

(57) The invention concerns a method for detecting a broken bar of a squirrel cage of an induction motor, the method comprises:
- determining (40) a signal representative of the current flowing through the at least one stator winding,
- computing (44) a Fourier Transform of the determined signal,
- determining (46) the fundamental frequency of the Fourier Transform of the determined signal,
- computing (50) an estimated rotor slip from the electric alternating power voltage applied to the stator windings and from signals representative of the current flowing through the stator windings,
- setting (52) a searching window from the estimated rotor slip and from the fundamental frequency,
- searching (54), a first peak and a second peak in the searching window,
g) checking (56, 58, 62) whether the frequency and/or the amplitude of the first peak and of the second peak fulfill at least one defined condition; if the at least one condition is fulfilled, generating a signal indicative of the presence of at least one broken bar.

FIG. 1

EP 4 756 444 A1

## Description

### Field of the invention

The invention concerns signal processing in the context of sensorless control of induction motor.

### Background

Induction motors are generally powered via a variable speed drive connected to the induction motor. Classic voltage/frequency control laws are more and more replaced by sensorless control laws that are able to control both the speed and the torque of the electrical motor, without a mechanical speed or position sensor except the variable speed drive.

In the context of the present invention, "sensorless" does not refer to the complete absence of sensors but to the absence of some sensors, such as rotor speed or position sensors. It, however, generally relies on measurements of motor currents (or potentially of motor voltages).

Induction motors are widely used in industry and are essential to industrial processes. Breakdown of induction motor not only leads to high repair expenses but also causes important financial losses due to unexpected downtime. A few induction motor failures result from a cracked or a broken rotor bar of the squirrel cage of the induction motor. Once the rotor bars are cracked or broken in the squirrel cage, the squirrel cage cannot generally be repaired. The squirrel cage fault can also lead to shaft vibration and thus bearing failures and air gap eccentricity, etc. Therefore, the early detection of broken rotor bars is essential not only for rotor protection but also for reducing other types of motor failures.

### Summary

An object of the present disclosure is to propose a method for detecting the cracked or broken bar of an induction motor without specific sensor. The method is specially adapted to the detection of a limited number of compromised bars, to mitigate the risk of fault propagation.

For reaching this object, the present disclosure presents a method for detecting a broken bar of a squirrel cage of an induction motor, the induction motor comprising a stator and a rotor , the stator comprising stator-windings to which an electric alternating power voltage is applied, the method being performed by a control device and a determination device configured to measure a signal representative of the current flowing through at least one stator winding, the method comprises:

a) determining a signal representative of the current flowing through the at least one stator winding,
b) computing a Fourier Transform of the determined signal,

c) determining the fundamental frequency of the Fourier Transform of the determined signal,
d) computing an estimated rotor slip from the electric alternating power voltage applied to the stator windings and from signals representative of the current flowing through the stator windings,
e) setting a searching window from the estimated rotor slip and from the fundamental frequency,
f) searching, a first peak and a second peak in the searching window, the first peak having a frequency greater to the frequency of the fundamental frequency and the second peak having a frequency lower to the frequency of the fundamental frequency,
g) checking whether the frequency and/or the amplitude of the first peak and of the second peak fulfill at least one defined condition; if the at least one condition is fulfilled, generating a signal indicative of the presence of one broken bar.

Advantageously, this method is cheap and easy to implement.

Optionally, the checking comprises comparing the difference between a first frequency interval and a second frequency interval to a defined threshold, the first frequency interval being comprised between the frequency of the fundamental frequency and the frequency of the first peak, the second frequency interval being comprised between the frequency of the fundamental frequency and the frequency of the second peak, and wherein the signal indicative of the presence of one broken bar is generated only if the difference between the first frequency interval and the second frequency interval is less than a defined threshold.

Optionally, the checking comprises comparing the amplitude of the first peak and the amplitude of the second peak is to a defined amplitude, and wherein the signal indicative of the presence of one broken bar is generated only if the amplitude of the first peak and the amplitude of the second peak is greater than the defined amplitude.

Optionally, the defined amplitude is greater to 2% of the amplitude of the fundamental frequency.

Optionally, the searching window is bounded by a first limit frequency and a second limit frequency, the first limit frequency being equal to the fundamental frequency minus n-times the estimated rotor slip multiplied by the fundamental frequency, the second limit frequency being equal to the fundamental frequency plus n-times the estimated rotor slip multiplied by the fundamental frequency; n being a real number comprises between 2 and 4.

Optionally, the determined signal is windowed by a Hann window before the computing of the Fourier transform.

Optionally, the determined signal is sampled, and the Fourier Transform computed is a Discrete Fourier Transform.

Optionally, a notch filter is applied to the Fourier Transform of the determined signal to reject a narrow band centred on the fundamental frequency.

Optionally, the determined signal is the current flowing through at least one stator-winding.

Optionally, the stator comprises a first stator-winding, a second stator winding and a third stator-winding, steps a) to g) being performed on the first stator-winding, the second stator winding and the third stator-winding, and wherein the signal indicative of the presence of one broken bar is generated only if the at least one condition is fulfilled for the signal representative of the current flowing through the first stator winding, if the at least one condition is fulfilled for the signal representative of the current flowing through the second stator winding, if the at least one condition is fulfilled for the signal representative of the current flowing through the third stator winding.

Another object of the present disclosure is a variable speed drive, the variable speed drive comprising a processor, a memory operatively coupled to the processor, and an interface for coupling to an induction motor to be driven by the variable speed drive, wherein the variable speed drive is configured to perform a method as mentioned in the above features.

Another object of the present disclosure is a computer program product comprising computer program code tangibly embodied in a computer readable medium, said computer program code comprising instructions to, when provided to a computer system and executed, cause said computer to perform a method as mentioned in the above features.

Another object of the present disclosure is a data set representing, for example through compression or encoding, a computer program product as mentioned in the above feature.

**Brief description of the drawings**

[Fig. 1] is a schematic view of a block diagram of an electric drive assembly comprising a variable speed drive according to the present disclosure.

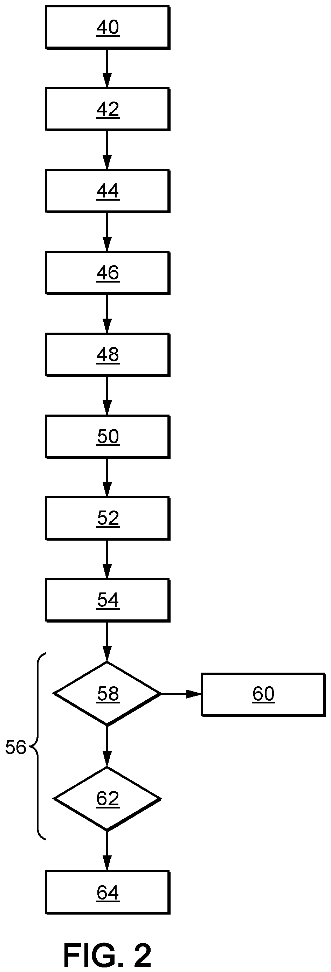

[Fig. 2] is a flowchart of the method according to the present disclosure.
[Fig. 3] is an example of a Discrete Fourier Transform of a current flowing through a stator-winding of an induction motor having one broken bar.
[Fig. 4] is a flowchart of the method according to a second embodiment of the present disclosure.

**Detailed description**

The disclosure applies to a method for detecting at least one broken bar of a squirrel cage of an induction motor.

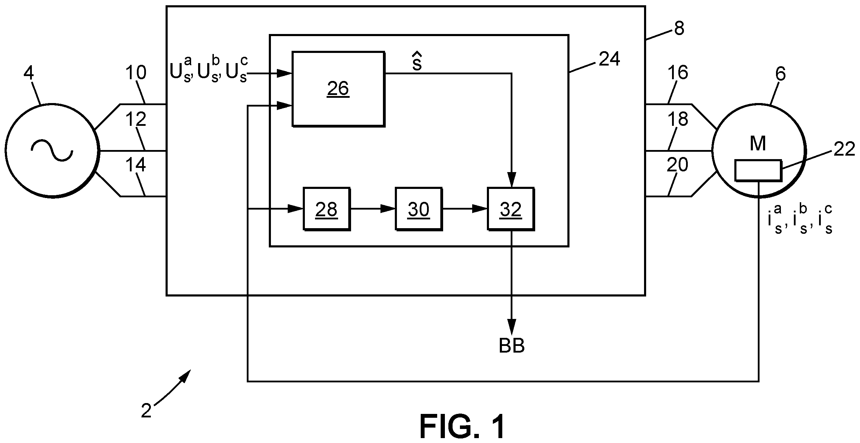

An example of an electric drive assembly 2 comprising a variable speed drive according to the disclosure is illustrated in figure 1.

The electric drive assembly 2 of figure 1 comprises an electric network 4, a variable speed drive 8 connected to the electric network, an induction motor 6 connected to the variable speed drive 8..

The induction motor 6 comprises a stator and a rotor. The rotor comprises a squirrel cage which is constituted by two end-rings connected by bars. The stator comprises a first winding, a second winding and a third winding which are not represented in figure 1.

The electric network 4 is a three-phase network which supplies an electric alternating power signal to the variable speed drive 8. To this end, electric network 4 comprises three electric network phases 10, 12, 14 which are respectively connected to three entries of the variable speed drive 8. The variable speed drive 8 comprises three outputs 16, 18, 20 adapted to be respectively connected to the three stator windings of the induction motor 6.

The variable speed drive 8 is configured to supply electric alternating power voltage $U_s^a, U_s^b, U_s^c$ to the stator-windings of the induction motor. The electric alternating power voltage $U_s^a, U_s^b, U_s^c$ is the control voltage of the induction motor.

In the embodiment illustrated in FIG. 1, the electric drive assembly 2 comprises a determination device 22 for measuring a signal representative of the instantaneous current $i_s^a, i_s^b, i_s^c$ flowing through each stator winding. This signal may be the instantaneous current itself. In this case, the determination device 22 comprises for example ammeters.

Alternatively, this signal can be the voltage between the terminals of the stator winding. In this case, the determination device 22 comprises for example voltmeters. It will be considered for the following of the description and in no way limiting manner that the determination device measures the instantaneous currents passing through each stator winding.

During the operating of the induction motor, the electric alternating power signal $U_s^a, U_s^b, U_s^c$ are supplied to the stator-windings to create a magnetic field that rotates in synchronism with the alternating oscillations. This rotating magnetic flux induces currents in the bars of the rotor squirrel cage. To oppose to the current change in the bars, the rotor turns in the direction of the stator magnetic field. The rotation of the rotor also induces a magnetic field in the stator windings. The current flowing through the stator windings and the voltage measured at the terminals of the stator windings are representative of the speed of rotation of the rotor when the induction motor has no defect, and especially when the bars of the squirrel cage are not broken. The rotor rotates at a somewhat slower speed than the stator's magnetic field. Because of the difference between the rotational speed of the stator's magnetic field and the rotational speed of the rotor, induction motors are sometimes called "asynchronous motors". The difference between the rotational speed of the stator's magnetic field and the rotational speed of the rotor divided by the rotational speed of the rotor is usually called "slip" .

$$s = (w_s - w_r)/w_s$$

where s is the slip,
$w_s$ is the rotational speed of the stator's magnetic field,
$w_r$ is the rotational speed of the rotor.

In the context of a "sensorless" control law i.e. without a rotor speed sensor or a position sensor, the slip s cannot be measured. The slip also varies according to the load of the induction motor.

Using a mathematical model of the induction motor, it has been theoretically proven that the frequencies of broken bars of the induction motor are defined by the following equation:

$$f_{\mathrm{BRB}} := (1 \pm 2ks)f_s, \quad k \in \mathbb{N}^*$$

Where

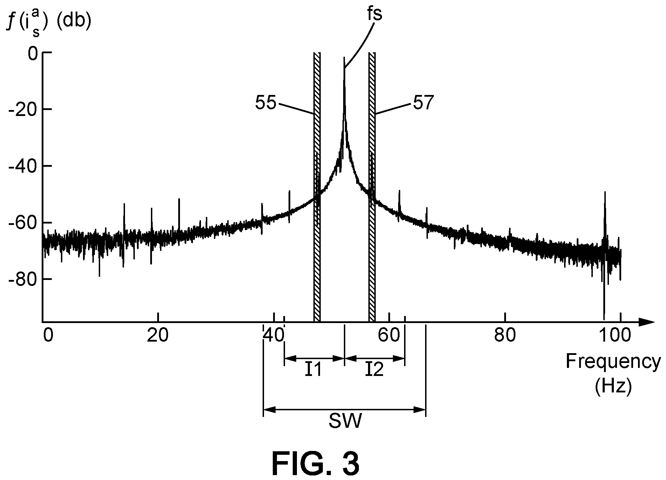

- $f_{BRB}$ is the frequency of the broken bars,
- k is a non zero natural integer,
- s is the slip,
- $f_s$ is the fundamental frequency of the alternating electrical signal measured between the terminals of the first stator-winding. In the example illustrated in Figure 3, $f_s$ is the fundamental frequency of the current if flowing through the first stator winding.

In figure 1, the variable speed drive 8 comprises a processor 24, for example a controller or a microcontroller.

Processor 24 is configured to operate according to the method hereby described. The processor may comprise electronic circuits for computation managed by an operating system.

The variable speed drive 8 may also comprise a non-transitory machine-readable or computer readable storage medium. The storage medium is encoded with instructions executable by a processor such as processor 24 to perform the example method hereby described.

A computer readable storage unit according to this disclosure may be any electronic, magnetic, optical or other physical storage device that stores executable instructions. The computer readable storage unit may be, for example, Random Access Memory (RAM), an Electrically Erasable Programmable Read Only Memory (EEPROM), a storage drive, and optical disk, and the like.

The processor 24 comprises an observer 26 configured to compute an estimate rotor slip ŝ from the currents if flowing through the stator-windings determined by the determination device 22 and from the control voltage applied to the stator-windings.

. In particular, the estimate rotor slip ŝ is computed from the current if flowing through the first stator-winding, the current $i_s^b$ flowing through the second stator-winding, the current $i_s^c$ flowing through the third-stator winding, the electric alternating power voltage $U_s^a$ applied to the first stator-winding, the electric alternating power voltage $U_s^b$ applied to the second stator-winding, the electric alternating power voltage $U_s^c$ applied to the third stator-winding..

The processor 24 comprises a Fourier transform unit 28 connected to the determination device 22.

The Fourier transform unit 28 is configured to receive a signal representative of the current if flowing through the first stator winding and to compute the spectrum of this signal.

In some examples, the Fourier transform unit 28 is configured to sample the received signal and to perform a Discrete Fourier Transform on it.

In some examples, the Fourier transform unit 28 is configured to receive also a signal representative of the current $i_s^b$ flowing through the second stator-winding and to compute its spectrum.

In some examples, the Fourier transform unit 28 is also configured to receive also a signal representative of the current $i_s^c$ flowing through the third stator-winding and to compute its spectrum.

The processor 24 comprises a filter unit 30 connected to Fourier transform unit 28. The filter unit 30 is configured to identify the fundamental frequency of the Fourier Transform of the determined signal issued from unit 28. Filter unit 30 is configured to remove the fundamental frequency signal from the Fourier Transform of the determined signal.

The processor 24 can comprise a notch filter which is not represented in Figure 1. The processor 24 comprises a broken bar detection unit 32. The broken bar detection unit 32 is connected to the observer 26 and to the filter unit 30. The broken bar detection unit 32 is configured to check whether or not the induction motor 6 comprises at least one broken bar. The broken bar detection unit 32 is configured to generate a signal BB indicative of the presence of a broken bar upon detection of the presence of at least one broken bar.

In the example of figure 1, observer 26, the Fourier transform unit 28, the filter unit 30 and the broken bar detection unit 32, are each realized, i.e. implemented, as software executable by processor 24.

At a step **40,** the method according to the present disclosure comprises the determining of a signal representative of the current if flowing through the first stator winding, by the determination device 22. This signal is determined for example by measuring.

It will be considered for the following of the description and in a no way limiting manner that the determination device 22 measures the instantaneous current $i_s^a$ passing through the first stator winding. Alternatively, the determination device 22 could also determine the voltage between the terminals of the first stator-winding.

At a step **42,** the method comprises the sampling of the determined current $i_s^a$. The determined current if can for example be sampled at 4 kHz during a time window of 20 seconds. A time window can be applied to the sampled current if to enhance its spectral resolution. For example, a Hann window can be applied.

At a step **44,** the method comprises the computing of the spectrum of the determined current if. A Discrete Fourier Transform (DFT) of the determined current if is computed. Figure 3 illustrates an example of the amplitude of the Discrete Fourier Transform (DFT) of the determined current if of the first stator-winding of an induction motor having one broken bar.

Alternatively, the method does not comprise a step 42. In this case, a time window is applied to the determined current in analog form and a Fourier Transform (FFT) is computed on the determined current if.

At a step **46,** the method comprises the identification of the fundamental frequency $f_s$ as the highest peak of the Discrete Fourier Transform (DFT) of the determined current $i_s^a$. This identification can for example be made by comparing two by two the amplitudes of the Discrete Fourier Transform (DFT) in a table. The fundamental frequency $f_s$ can be removed from the Discrete Fourier Transform (DFT) of the determined current if. In the example of figure 3, the fundamental frequency $f_s$ has a frequency of 53 Hz.

At a step **48,** to increase the recovery accuracy, the method can comprise the applying of a notch filter to attenuate the lobe around the fundamental frequency $f_s$.

At a step **50,** the method comprises the computing an estimated rotor slip $\hat{s}$. The estimated rotor slip $\hat{s}$ is estimated by the observer 26 from the current $i_s^a$ flowing through the first stator winding and from the electric alternating power voltage $U_s^a$ applied to the terminals of the first stator winding. This estimated rotor slip $\hat{s}$ is biased because when a broken bar fault occurs, the discrepancy between the physical system and the mathematical model increases significantly.

At a step **52,** the method comprises the setting of a searching window SW from the estimated rotor slip $\hat{s}$ and from the fundamental frequency $f_s$. The searching window SW is bounded by a first limit frequency and a second limit frequency.

In some examples, the first limit frequency is equal to the fundamental frequency minus n-times the estimated rotor slip $\hat{s}$ multiplied by the fundamental frequency. The second limit frequency being equal to the fundamental frequency plus n-times the estimated rotor slip $\hat{s}$ multiplied by the fundamental frequency.

The searching window SW is equal to $[\![f_s - n\hat{s}f_s, f_s + n\hat{s}f_s]\!]$. The number n is a real number comprises between 2 and 4.

For example, the number n is equal to 2.5.

According to another example, the number n is equal to 3. In this case, the searching window SW is equal to $[\![f_s - 3\hat{s}f_s, f_s + 3\hat{s}f_s]\!]$.

The closer the value of the number n is to 2, the faster the detection of a broken bar will be. If the value of the number n is higher, the chances of detecting a broken bar are increased even in cases where the deviation of the slip is significant.

At a step **54,** the method comprises the searching, in the searching window SW, of a first peak 55 having a frequency above the fundamental frequency $f_s$ and of a second peak 57 having a frequency below the fundamental frequency $f_s$. This search can be done using a peak-finding algorithm.

Theoretically, if the rotor comprises one broken bar, a first peak should have a frequency of $f_s - 2sf_s$. A second peak should have a frequency of $f_s + 2sf_s$. However, due to the discrepancy between the slip of the induction motor having a broken bar and the estimated rotor slip §, the searching is conducted in a larger searching window SW.

At a step **56,** the method comprises the checking that the frequency and/or the amplitude of the first peak 55 and that the frequency and/or the amplitude of the second peak 57 meet at least one defined condition.

In some examples, the defined condition is that the first peak 55 and the second peak 57 are spaced approximately from the same frequency range from the fundamental frequency $f_s$.

To check this condition, the method comprises the determining of a first frequency interval I1 and of a second frequency interval I2, during a step **58.**

The first frequency interval I1 comprises the frequencies between the fundamental frequency $f_s$ and the first peak 55. The first frequency interval I1 can be obtained by computing the difference between the frequency of the fundamental frequency $f_s$ and the frequency of the first peak 55. The second frequency interval I2 comprises the frequencies between the fundamental frequency $f_s$ and the second peak 57. The second frequency interval I2 can be obtained by computing the difference between the frequency of fundamental frequency $f_s$ and the frequency of the second peak 57. The method also comprises the computing of the difference between the first frequency interval I1 and the second frequency interval I2. At least during step **58,** the difference is compared to a defined threshold S1.

For example, the threshold S1 is equal to 0,1 Herz.

According to a first embodiment, when the difference between the first frequency interval I1 and the second frequency interval I2 is less than the first defined threshold S1, a signal BB indicative of the presence of at least one broken bar is generated, at a step **60.**

According to a second embodiment, when the difference between the first frequency interval I1 and the second frequency interval I2 is less than the first defined threshold S1, the method comprises the checking of a second defined condition, at a step **62.** In some examples, the second defined condition is that the amplitude of the first peak 55 and of the second peak 57 are greater to a defined amplitude A.

To check this condition, the method comprises comparing the amplitude of the first peak 55 and the amplitude of the second peak 57 to a defined amplitude A, during step **62.**

Preferably, the defined amplitude A is equal or greater to 2% of the amplitude of the fundamental frequency $f_s$.

Alternatively, the defined amplitude A is a value predefined which is independent from the amplitude of the fundamental frequency $f_s$ and more generally which is independent from the determined signal $i_s^a$.

If the amplitude of the first peak 55 and the amplitude of the second peak 57 is greater than the defined amplitude A, a signal BB indicative of the presence of at least one broken bar is generated, at a step **64.**

The method according to the present disclosure can be applied only to the first stator-winding. In this case, steps 40 to 64 are implemented only to a signal representative of the current $i_s^b$ flowing through the first stator-winding.

Alternatively, steps 40 to 64 are repeated for the second stator-winding. In step 40, a signal representative of the current $i_s^b$ flowing through the second stator-winding is determined. Steps 42 to 64 are implemented on this signal representative of the current $i_s^b$.

In this case, a signal indicative of the presence of one broken bar is generated only if the at least one condition is fulfilled for the signal if representative of the current flowing through the first stator-winding and for the signal $i_s^b$ representative of the current flowing through the second stator-winding.

If the at least one condition is fulfilled only for one signal among the signal $i_s^a$ representative of the current flowing through the first stator-winding and the signal $i_s^b$ representative of the current flowing through the second stator-winding, a signal indicative of the presence of a problem on the stator is generated.

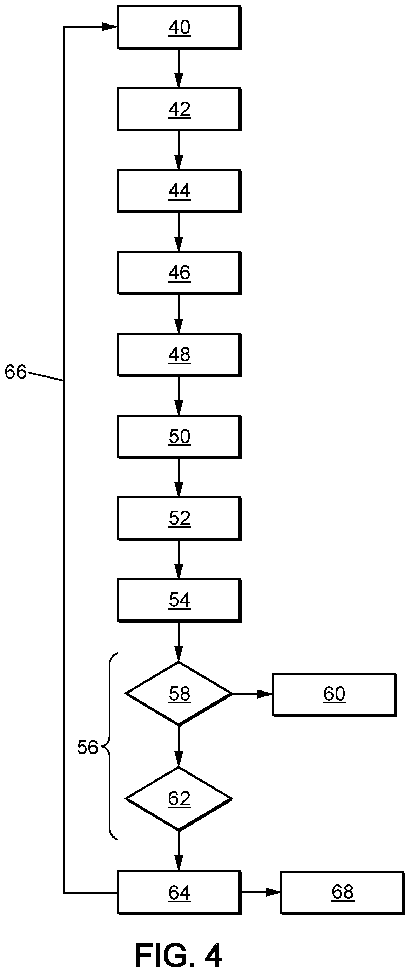

Alternatively, in reference to figure 4, steps 40 to 64 are performed once for the first stator-winding. Then, steps 40 to 64 are repeated, at step 66; for the second stator-winding and for the third stator-winding. In this case, at step 40, a signal representative of the current $i_s^b$ flowing through the second stator-winding is determined.

Steps 40 to 64 are once again repeated, at step 66; for the third stator-winding. In this later case, at step 40, a signal representative of the current $i_s^c$ flowing through the third stator-winding is determined.

According to this embodiment illustrated in figure 4, a signal BB indicative of the presence of one broken bar is generated at step 68 only if the at least one condition is fulfilled for the signal $i_s^a$ representative of the current flowing through the first stator-winding, for the signal $i_s^b$ representative of the current flowing through the second stator-winding and for the signal $i_s^c$ representative of the current flowing through the third stator winding.

If the at least one condition is fulfilled only for one signal among the signal if representative of the current flowing through the first stator-winding, the signal $i_s^b$ representative of the current flowing through the second stator-winding and the signal $i_s^c$ representative of the current flowing through the third stator-winding, a signal indicative of the presence of a problem on the stator is generated

**Claims**

1. A method for detecting a broken bar of an induction motor, the induction motor comprising a stator and a rotor, the stator comprising stator-windings to which an electric alternating power voltage ( $U_s^a, U_s^b, U_s^c$ ) is applied, the method being performed by a control device (24) and a determination device (22) configured to measure a signal representative of the current flowing through at least one stator winding, the method comprises:

   a) determining (40) a signal ( $i_s^a$ , $i_s^b$ , $i_s^c$ ) representative of the current flowing through the at least one stator winding,
   b) computing (44) a Fourier Transform of the determined signal,
   c) determining (46) the fundamental frequency ($f_s$) of the Fourier Transform of the determined signal ( $i_s^a$ , $i_s^b$ , $i_s^c$ ),
   d) computing (50) an estimated rotor slip ($\hat{s}$) from the electric alternating power voltage ( $U_s^a, U_s^b, U_s^c$ ) applied to the stator windings and from signals ( $i_s^a$ , $i_s^b$ , $i_s^c$ ) representative of the current flowing through the stator windings,

e) setting (52) a searching window (SW) from the estimated rotor slip ($\hat{s}$) and from the fundamental frequency ($f_s$),

f) searching (54), a first peak (55) and a second peak (57) in the searching window (SW), the first peak (55) having a frequency greater to the frequency of the fundamental frequency ($f_s$) and the second peak (57) having a frequency lower to the frequency of the fundamental frequency ($f_s$),

g) checking (56, 58, 62) whether the frequency and/or the amplitude of the first peak and of the second peak fulfill at least one defined condition; if the at least one condition is fulfilled, generating a signal (BB) indicative of the presence of at least one broken bar.

2. The method according to claim 1, wherein the checking comprises comparing (58) the difference between a first frequency interval (I1) and a second frequency interval (I2) to a defined threshold (S1), the first frequency interval being comprised between the frequency of the fundamental frequency ($f_s$) and the frequency of the first peak (55), the second frequency interval (I2) being comprised between the frequency of the fundamental frequency ($f_s$) and the frequency of the second peak, and wherein the signal (BB) indicative of the presence of one broken bar is generated only if the difference between the first frequency interval and the second frequency interval is less than a defined threshold (S1).

3. The method according to any of claims 1 and 2, wherein the checking comprises comparing (62) the amplitude of the first peak (55) and the amplitude of the second peak (57) is to a defined amplitude (A), and wherein the signal (BB) indicative of the presence of one broken bar is generated only if the amplitude of the first peak and the amplitude of the second peak is greater than the defined amplitude (A).

4. The method according to claim 3, wherein the defined amplitude (A) is greater to 2% of the amplitude of the fundamental frequency.

5. The method according to any of claims 1 to 4, wherein the searching window (SW) is bounded by a first limit frequency and a second limit frequency, the first limit frequency being equal to the fundamental frequency minus n-times the estimated rotor slip multiplied by the fundamental frequency, the second limit frequency being equal to the fundamental frequency plus n-times the estimated rotor slip multiplied by the fundamental frequency; n being a real number comprises between 2 and 4.

6. The method according to any of claims 1 to 5, wherein the determined signal ( $i_s^a$ , $i_s^b$ , $i_s^c$ ) is windowed (42) by a Hann window before the computing of the Fourier transform.

7. The method according to any of claims 1 to 6, wherein the determined signal ( $i_s^a$ , $i_s^b$ , $i_s^c$ ) is sampled (42), and the Fourier Transform computed is a Discrete Fourier Transform.

8. The method according to any of claims 1 to 7, wherein a notch filter (48) is applied to the Fourier Transform of the determined signal ( $i_s^a$ , $i_s^b$ , $i_s^c$ ) to reject a narrow band centred on the fundamental frequency ($f_s$).

9. The method according to any of claims 1 to 8, wherein the determined signal is the current ( $i_s^a$ , $i_s^b$ , $i_s^c$ ) flowing through at least one stator-winding.

10. The method according to any of claims 1 to 9, wherein the stator comprises a first stator-winding, a second stator winding and a third stator-winding, steps a) to g) being performed (66) on the first stator-winding, the second stator winding and the third stator-winding, and wherein the signal (BB) indicative of the presence of one broken bar is generated (68) only if the at least one condition is fulfilled for the signal (if) representative of the current flowing through the first stator winding, if the at least one condition is fulfilled for the signal ( $i_s^b$ ) representative of the current flowing through the second stator winding, if the at least one condition is fulfilled for the signal ( $i_s^c$ ) representative of the current flowing through the third stator winding.

11. A variable speed drive, the variable speed drive comprising a processor, a memory operatively coupled to the processor, and an interface for coupling to an induction motor to be driven by the variable speed drive, wherein the variable speed drive is configured to perform a method according to any of claims 1 to 10.

12. A computer program product comprising computer program code tangibly embodied in a computer readable medium, said computer program code comprising instructions to, when provided to a computer system and executed, cause said computer to perform a method according to any of claims 1 to 10.

**13.** A data set representing, for example through compression or encoding, a computer program product according to claim 12.

**FIG. 1**

EP 4 756 444 A1

**FIG. 2**

FIG. 3

FIG. 4

**Europäisches Patentamt**
**European Patent Office**
**Office européen des brevets**

# EUROPEAN SEARCH REPORT

**Application Number**

EP 24 30 7051

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 049 815 A (KLIMAN GERALD B [US]) 17 September 1991 (1991-09-17) * the whole document * | 1-13 | INV. G01R31/34 |
| A | US 4 761 703 A (KLIMAN GERALD B [US] ET AL) 2 August 1988 (1988-08-02) * column 2, lines 61-62; claims 1,4,5; figure 1 * | 1-13 | |
| A | US 6 144 924 A (DOWLING MARTIN JOSEPH [US] ET AL) 7 November 2000 (2000-11-07) * figure 7 * | 1-13 | |
| A | US 2015/260794 A1 (ATHIKESSAVAN SUBASH C [SG] ET AL) 17 September 2015 (2015-09-17) * claim 4 * | 1-13 | |

**TECHNICAL FIELDS SEARCHED (IPC)**

G01R

The present search report has been drawn up for all claims

| Place of search | Date of completion of the search | Examiner |
|---|---|---|
| Munich | 20 May 2025 | Dogueri, Ali Kerem |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 30 7051

This annex lists the patent family members relating to the patent documents cited in the above-mentioned European search report.
The members are as contained in the European Patent Office EDP file on
The European Patent Office is in no way liable for these particulars which are merely given for the purpose of information.

20-05-2025

| Patent document cited in search report | | Publication date | Patent family member(s) | | Publication date |
|---|---|---|---|---|---|
| US 5049815 | A | 17-09-1991 | NONE | | |
| US 4761703 | A | 02-08-1988 | NONE | | |
| US 6144924 | A | 07-11-2000 | US 6144924 A | | 07-11-2000 |
| | | | US 6236947 B1 | | 22-05-2001 |
| | | | US 6308140 B1 | | 23-10-2001 |
| US 2015260794 | A1 | 17-09-2015 | EP 2919027 A1 | | 16-09-2015 |
| | | | US 2015260794 A1 | | 17-09-2015 |

EPO FORM P0459

For more details about this annex : see Official Journal of the European Patent Office, No. 12/82